# EUROPEAN PATENT APPLICATION

(11) **EP 4 845 317 A1**
(43) Date of publication of application: **25.11.2026**
(21) Application number: 25177291.9
(22) Date of filing: 19.05.2025
(51) Int. Cl.: H05K 5/00

(54) **VEHICULAR ELECTRONIC CONTROL UNIT, HOUSING, VEHICLE AND METHOD FOR PRODUCING A VEHICULAR ELECTRONIC CONTROL UNIT**

(71) Applicant: ZF CV Systems Global GmbH, 3006 Bern (CH)
(72) Inventor: SZCZERBA, Dominik, 55-040 Domaslaw (PL); WOLANSKI, Michal, 54-129 Wroclaw (PL)
(74) Representative: Copi, Joachim

(57) **Abstract**

The invention relates to a vehicular electronic control unit (10), comprising: a housing (11) with a base (12), a cover (13) and a back wall (14) connecting the base (12) with the cover (13); a PCB holder (15) protruding from the back wall (14) of the housing (11); and a printed circuit board (30) supported by the PCB holder (15) and having electronic components (31) mounted thereon, wherein the PCB holder (15) comprises a recess (16) extending in parallel to an outer edge (32) of the printed circuit board (30); the recess (16) is at least partially filled with an elastic material (17); and the outer edge (32) of the printed circuit board (30) is pushed into the elastic material (17). Furthermore, the invention relates to a housing (11) for such a vehicular electronic control unit (10) and to a vehicle (40), in particular a commercial vehicle (40a), comprising such a vehicular electronic control unit (10). In addition, the invention relates to a method (100) for producing such a vehicular electronic control unit (10).

## Description

The present disclosure relates to a vehicular electronic control unit comprising a housing, a PCB holder and a printed circuit board. Furthermore, the present disclosure relates to a housing for such a vehicular electronic control unit and to a vehicle, in particular a commercial vehicle, comprising such a vehicular electronic control unit. Moreover, the present disclosure relates to a method for producing such a vehicular electronic control unit.

Vehicular electronic control units are generally known from prior art and can be regarded as electronic devices with electronic control components being implemented in a vehicle for controlling at least one vehicle-related function, such as driving, braking, driver assistance or comfort functions. The electronic control components may be arranged on the printed circuit board and the PCB holder (printed circuit board holder) may be configured to support the printed circuit board in the housing of the vehicular electronic control unit. The housing serves to protect the printed circuit board from environmental conditions and impacts.

Several technical approaches have been presented to optimize the support of the printed circuit board in the housing of a vehicular electronic control unit in order to reduce mechanical stress in the printed circuit board, in particular in view of characteristic environmental conditions in vehicles such as vibration and shock forces. For instance, in DE 10 2007 015 938 A1 an arrangement for the installation of electronic components in motor vehicles is disclosed. The arrangement comprises a housing with a lid and a printed circuit board with electronic components. The housing comprises at least one PCB holder protruding from a housing base in the direction of an underside of the printed circuit board. The printed circuit board is supported by and/or connected to the at least one PCB holder via a foam material.

In EP 2 653 018 A1, a control unit for a motor vehicle is described, the control unit comprising a rack housing and a printed circuit board arranged therein. At least one damping element is arranged on the printed circuit board and contacts a deformation element of the housing when the printed circuit board is fully inserted in the rack housing.

IN 2023 410 313 19 A relates to a structure for securing a printed circuit board in a vehicle. The structure comprises a casing and a pair of continuous grooves running in parallel to each other on inner surfaces of the casing. The printed circuit board comprises cushioning pads being arranged on longitudinal sliding edges of the printed circuit board, the sliding edges being configured to slide within the pair of continuous grooves.

Although the technical approaches presented above may contribute to an enhanced support of a printed circuit board in a housing of a vehicular electronic control unit, the technology still holds potential for improved support performance and a facilitated production process for providing a vehicular electronic control unit with a refined PCB support concept. In view of the above, it is a general object of the present invention to address one or more of the disadvantages associated with the prior art. In particular, it is an object of the present invention to provide a vehicular electronic control unit which is easy to assemble and ensures less mechanical stress in the printed circuit board being hold by the PCB holder in the housing. It is a further object of the present invention to provide a suitable housing for such a vehicular electronic control unit and a vehicle being equipped with such a vehicular control unit. It is a further object of the present invention to provide a facilitated method of producing such a vehicular electronic control unit.

Aspects and embodiments of the invention provide a vehicular electronic control unit (hereinafter also referred to as vehicular ECU), a housing, a vehicle and a method for producing a vehicular electronic control unit as indicated in the appended claims.

According to a first aspect of the present invention, there is provided a vehicular electronic control unit, comprising:
- a housing with a base, a cover and a back wall connecting the base with the cover,
- a PCB holder protruding from the back wall of the housing, and
- a printed circuit board supported by the PCB holder and having electronic components mounted thereon,
wherein:
- the PCB holder comprises a recess extending in parallel to an outer edge of the printed circuit board,
- the recess is at least partially filled with an elastic material, and
- the outer edge of the printed circuit board is pushed into the elastic material.

With a recess being at least partially filled with an elastic material, the PCB holder acts as a flexible clamp holder for clamping the outer edge of the printed circuit board in a soft and resilient manner. Such a flexible clamp holder may significantly reduce mechanical stress in the printed circuit board being supported by the PCB holder, resulting in a decreased risk of micro cracks and damages of the printed circuit board during its lifetime. Furthermore, the elastic material allows for vibration damping in the support area of the printed circuit board.

Being configured as a back wall holder, the PCB holder does not apply vertical forces to a functionally important central area of the printed circuit board, which may present a particular advantage over vertical PCB holders protruding from the base or cover of the housing. Furthermore, the PCB holder arranged on the back wall of the housing provides a space-saving support concept compared to vertical PCB holders protruding from the base or cover of the housing.

The elastic material in the recess of the PCB holder allows for self-adaptation upon receiving the outer edge of the printed circuit board, which means that it adapts to the contour and dimension of the outer edge. Hence, the elastic material provides tolerance compensation, which may, for instance, be advantageous in view of thickness variations due to a lacquer coating on the printed circuit board. Furthermore, slight deviations from a preferred orientation angle of the supported printed circuit board may be compensated by the elastic material. In addition, width variations of the printed circuit board can be compensated due to an inherent spring force of the elastic material, which may contribute to an improved hold of the printed circuit board in the housing.

The vehicular ECU according to the first aspect can be easily assembled by inserting the printed circuit board into the housing and pushing its outer edge into the elastic material of the PCB holder, which allows for a more comfortable and careful handling compared to an insertion of the outer edge into a rigid holding structure of a non-flexible PCB holder. Furthermore, the vehicular ECU according to the first aspect does not require the printed circuit board to be equipped with cushioning pads or damping elements, in this way facilitating the production process and an insertion of the printed circuit board without being affected by the stopping properties of a cushioning pad in a sliding groove or by a damping element attached to the printed circuit board.

The vehicular ECU may be configured to be implemented in a vehicle, in particular in a commercial vehicle such as a truck or bus, or alternatively in a non-commercial vehicle such as a car. Generally, the vehicle may be a motor vehicle of any type designed to transport people and/or cargo. In particular, the vehicular ECU may be configured as a cabin-mounted ECU, such that major vibrations and shocks during the vehicle operation may already be absorbed by a cabin damping system.

As indicated above, the vehicular ECU comprises a housing with a base, a cover and a back wall connecting the base with the cover. The base and the cover of the housing may essentially extend in parallel to each other and the back wall may essentially extend perpendicular to the base and the cover. The base may define a bottom of the housing and the cover may define a top side of the housing. The printed circuit board is arranged in the interior of the housing, where it may be positioned closer to the base than to the cover in order to provide enough space for the electronic components mounted on the printed circuit board. The printed circuit board may essentially extend along the housing, preferably being spaced from the base and the cover, and the surface of the printed circuit board supporting the electronic components may essentially extend in parallel with the base of the housing. The printed circuit board may be connected to a connector panel by solder connections. The connector panel may form a detachable front wall or front closure of the housing, being arranged opposite of the back wall comprising the PCB holder. The housing may, for instance, be a metal housing, such as an aluminum housing, or a synthetic housing, such as a plastic housing. At least a part of the housing may, for instance, be manufactured by deep drawing, injection molding, sheet metal bending, 3D printing, etc. A front wall and the back wall of the housing may be connected by side walls extending essentially perpendicular to the back wall and the front wall and perpendicular to the cover and the base. Generally, at least one of the base, the cover, the back wall, the front wall and the side walls may form an integral part of the housing or a separate detachable part of the housing. In other words, the housing may have a single-component or a multi-component body.

As indicated above, the PCB holder protrudes from the back wall of the housing. According to an embodiment, the PCB holder may essentially extend along the back wall with a length parallel to the back wall being higher than a width perpendicular to the back wall. For instance, the PCB holder may be configured as an elongated rail with a groove extending along the length of the rail, the groove forming the recess of the PCB holder. The recess of the PCB may be partially or fully filled with the elastic material.

As indicated above, the outer edge of the printed circuit board is pushed into the elastic material. Hence, the outer edge may be received by the elastic material and surrounded by it. In particular, the elastic material may contact the upper surface and the lower surface of the printed circuit board in the area of the outer edge, thus providing a flexible clamping fixation with the advantage of reduced mechanical tension in the printed circuit board.

According to an embodiment of the first aspect of the present invention, the elastic material may be a foam material. Foam materials present cost-efficient elastic materials which are easy to process. Furthermore, the foam material may be also used for sealing of the housing, thus enabling efficient multifunctional use of the foam material during manufacturing of the vehicular ECU. The foam material may, for instance, be Elastosil SC 870.

According to an embodiment of the first aspect of the present invention, the housing may be configured as a rack housing for slidable insertion of the printed circuit board, wherein the back wall is facing a leading outer edge of the printed circuit board in a direction of insertion and wherein at least one side wall adjacent to the back wall comprises a guiding element receiving the printed circuit board in a slidable manner. In this way, the PCB holder becomes effective at the end of the insertion of the printed circuit board, whereas the insertion movement itself is not inhibited by the elastic material compared to technical approaches comprising a printed circuit board being equipped with cushioning pads engaging grooves in the side walls of the housing. Furthermore, high stability of the printed circuit board during insertion and additional hold of the printed circuit board is given by the guiding elements on the side walls in which further outer edges of the printed circuit board may rest upon full insertion of the printed circuit board into the housing. By providing additional hold, reduced bending of the printed circuit board may be achieved. In addition, by providing a rack housing for slidable insertion of the printed circuit board, the vehicular ECU is easy to assemble. In this regard, the rack housing may be configured to receive the printed circuit board by sliding insertion in a defined direction, which means that the printed circuit board is moved along the guiding elements in the side walls towards the back wall. Hence, the housing may comprise an insertion opening opposite of the back wall, which may be closed by a detachable lid or by a connector panel as described above upon full insertion of the printed circuit board. The back wall may extend perpendicular to the direction of insertion. Preferably, both adjacent side walls adjoining the back wall may each comprise a guiding element. The guiding element may, for instance, be a guiding rail. According to an embodiment, the guiding element and the PCB holder may comprise the same structure or shape, which allows for easy manufacturing of the vehicular ECU. For example, the guiding element and the PCB holder may be configured as elongated rails with a groove as a recess. Nevertheless, it is preferred that only the PCB holder is filled with an elastic material so that the PCB holder becomes effective at the end of the insertion, whereas the insertion movement itself is not inhibited by elastic material being present in the guiding element.

According to an embodiment of the first aspect of the present invention, the PCB holder may comprise a holder profile with an open cross-section. The open cross-section allows and facilitates the insertion of the elastic material into the recess of the PCB holder as well as the insertion of the outer edge into the elastic material. In particular, the holder profile may have a cross-section on one side open. The opening of the open cross-section may be directed to the outer edge of the printed circuit board designated to be received by the PCB holder. For instance, the holder profile may be U-shaped, C-shaped or V-shaped. PCB holders with such a holder profile are easy to manufacture either integrally with the back wall or as a separate component. Furthermore, holder profiles with a radius may improve adhesion of the elastic material in the recess, but its not necessary for providing the elastic function.

According to an embodiment of the first aspect of the present invention, the recess may comprise a height being larger than the thickness of the printed circuit board. In this way, potential thickness variations of the printed circuit board can be compensated in a reliable manner and it may be easier to insert the outer edge of the printed circuit board into the recess. Furthermore, an enlarged recess may ensure that sufficient elastic material is present in the recess to surround the outer edge of the printed circuit board for a safe flexible clamping function. According to a non-limiting example, the recess may comprise a height being at least 10 % larger than the thickness of the printed circuit board. Generally, the height of the recess may be defined by a recess extension in the direction between the cover and the base of the housing. The thickness of the printed circuit board may be defined by a thickness of the printed circuit board at the outer edge being supported by the PCB holder, the thickness being defined by a distance between the lower main surface and the upper main surface of the printed circuit board. In order to enable a higher damping effect, a more facilitated assembly or an improved tolerance compensation, the height of the recess may be at least 20 % larger than the thickness of the printed circuit board.

According to an embodiment of the first aspect of the present invention, the PCB holder may be formed as a continuous bar extending along the width of the back wall. In this way, the PCB holder presents an elongated horizontal PCB holder which is easy to manufacture and arranged in a space-saving manner on the back wall.

The width of the back wall may be defined by a an extension of the back wall perpendicular to the height and to the insertion direction. Generally, a horizontal extension or orientation may refer to an extension or orientation parallel to a main extension plane of the base of the housing, whereas a vertical extension or orientation may refer to an extension or orientation perpendicular to a main extension plane of the base of the housing.

According to an embodiment of the first aspect of the present invention, at least two spaced PCB holders may protrude from the back wall. In this way, an economical use of the holder material and the elastic material may be achieved. In other words, the PCB holder may be divided into at least two separate holder elements being spaced from each other on the back wall, thus presenting an interrupted holder profile. The spaced PCB holders may extend along a common straight line in order to provide a stable mechanical hold for the outer edge of the printed circuit board.

According to an embodiment of the first aspect of the present invention, the back wall may be configured as a detachable lid of the housing, which allows for a facilitated production and assembly of the vehicular ECU. For instance, the application of the elastic material may be easier if the back wall is a detachable lid. Furthermore, a detachable lid may enable retrofitting of existing housings with a back wall comprising the described PCB holder and to exchange a detachable lid with a specific PCB holder by a further detachable lid with a different PCB holder, e.g. such as a PCB holder of a different type or with different dimensions. In this way, increased flexibility for production and use of the vehicular ECU may be provided. With a detachable lid, the housing may present an open-type housing or multi-component housing with a back wall lid. The lid may be fixed to the housing in a detachable manner, e.g. by being snapped or screwed to the edges of a back wall opening in the housing. The detachable lid and/or the PCB holder attached to the lid may be exchangeable. If the housing is furthermore configured as a rack housing, it may have at least one insertion opening for insertion of the printed circuit board in a front wall area of the housing, which may be closed by a front wall lid or a connector panel, as well as a back wall opening which may be closed by the detachable lid.

According to an embodiment of the first aspect of the present invention, the PCB holder may be an integral component of the housing. In other words, the PCB holder may be produced in one piece with the housing, at least regarding a rigid structure of the PCB holder comprising the recess, meaning that the elastic material may be applied in a later step. In this way, the PCB holder can be easily provided, for instance by respective adaptation of a mold or tool for producing the housing, and the PCB holder formed integrally with the housing is attached to the back wall in a stable and safe manner.

According to an alternative embodiment of the first aspect of the present invention, the PCB holder may be a separate component being attached to the housing, which provides increased flexibility. For instance, a PCB holder position may be chosen individually and the PCB holder may be detachable for exchange. Furthermore, a separate component configuration of the PCB holder may facilitate the application of elastic material and enable to retrofit existing housings with the PCB holder. The PCB holder can be manufactured and provided separately from the housing, and it may, for instance, be attached to the housing using glue, screws or a latching mechanism.

According to a second aspect of the present invention, there is provided a housing for the vehicular electronic control unit according to any aspect or embodiment described herein, wherein
- the housing comprises a base, a cover and a back wall connecting the base with the cover,
- the housing comprises a PCB holder protruding from the back wall of the housing, the PCB holder being configured to support a printed circuit board,
- the PCB holder comprises a recess, and
- the recess is at least partially filled with an elastic material.

The housing according to the second aspect of the present invention provides an improved PCB support concept with a PCB holder acting as a flexible clamp holder for a printed circuit board. Hence, the housing comprising the PCB holder may significantly reduce mechanical stress in the printed circuit board, enable tolerance compensation regarding the shape and dimensions of the printed circuit board, provide vibration damping and present a space-saving holding structure. With a PCB holder protruding from the back wall of the housing, an outer edge of the printed circuit board may be pushed into the elastic material of the PCB holder in an easy and reliable manner.

According to a third aspect of the present invention, there is provided a vehicle, in particular a commercial vehicle, comprising the vehicular electronic control unit according to any aspect or embodiment described herein. With a vehicle comprising the vehicular ECU with an improved PCB support concept, the lifetime of the printed circuit board being supported in the vehicular ECU may be extended and a high performance of the electronic components mounted on the printed circuit board can be ensured. In this way, reliable vehicle-related functions performed by the electronic components can be maintained over a long time, thus enhancing an overall operation efficiency of the vehicle. As indicated above, the vehicle may in particular be a commercial vehicle, such as a truck or bus. Due to their dimensions and weight, commercial vehicles may be prone to intense vibration and shock forces, which may present a specific challenge for a vehicular ECU being implemented in a commercial vehicle. Hence, the vehicular ECU with an improved PCB support concept may beneficially be implemented in a commercial vehicle. In particular, the vehicular ECU may be configured as a cabin-mounted ECU in a commercial vehicle, such that major vibrations and shocks during the vehicle operation may already be absorbed by a cabin damping system. Nevertheless, the vehicular ECU may be also implemented in a non-commercial vehicle such as a passenger car.

According to a fourth aspect of the present invention, there is provided a method for producing a vehicular electronic control unit according to any aspect or embodiment described herein, comprising the steps of:
- providing a housing with a base, a cover and a back wall connecting the base with the cover,
- equipping the back wall with a PCB holder either by integral manufacturing or by subsequent attachment,
- filling elastic material into a recess of the PCB holder,
- inserting a printed circuit board into the housing, and
- joining an outer edge of the printed circuit board with the elastic material in the PCB holder protruding from the back wall.

With the method according to the fourth aspect of the present invention, a simple and efficient production of the vehicular ECU may be realized. The housing may be provided as a single-component housing with integral parts, i.e. an integral base, cover and back wall, or as a multi-component housing with detachable parts. For instance, the back wall may be configured as a detachable lid of the housing. The housing may, for instance, be provided using deep drawing or injection molding. As indicated, the PCB holder comprised by the back wall may be produced as an integral part of the housing or be provided separately and attached to the back wall. Depending on a configuration of the back wall either as an integral part or a detachable lid, joining an outer edge of the printed circuit board may include a relative movement of the PCB holder and the printed circuit board in which the PCB holder is moved towards the outer edge of the printed circuit board and/or in which the printed circuit board is moved towards the PCB holder. According to an embodiment, the elastic material may be firmly bonded to the recess of the PCB holder by curing in the recess after application. Hence, the elastic material may be applied to the recess in a semi-solid state and cure to an essentially solid state in the recess. If the PCB holder is manufactured separately and attached to the back wall after provision of the housing, the elastic material may be filled into the recess before the PCB holder is attached to the back wall.

According to an embodiment of the fourth aspect of the present invention, the method may further comprise the step of sealing the housing with the same elastic material being filled into the recess of the PCB holder, which may further improve the overall process efficiency. In this regard, sealing the housing may imply to equip housing wall edges limiting an opening of the housing, such as an insertion opening or a back wall lid opening, with the elastic material for tight enclosure. In particular, the elastic material may be a foam material which is easy to process for recess filling and sealing of the housing.

According to an embodiment of the fourth aspect of the present invention, the step of joining of the outer edge of the printed circuit board with the elastic material may be conducted while the elastic material is still curing. In this way, the elastic material may be also firmly bonded to the outer edge of the printed circuit board which provides a stronger hold and may contribute to reduce mechanical stress and strains in the supported printed circuit board.

The above and other characteristics will become clear from the following description of illustrative, non-restrictive examples, which will be further outlined with reference to the appended drawings. The drawings are not necessarily to scale. Some features could be exaggerated or minimized to show details of particular components.

Therefore, specific structural and functional details disclosed herein are not to be interpreted as limiting, but merely as a representative basis for teaching one skilled in the art.
- Fig. 1: shows a sectional perspective view of a vehicular electronic control unit according to an embodiment with a partially inserted printed circuit board.
- Fig. 2: depicts the vehicular electronic control unit according to Fig. 1 with a fully inserted printed circuit board.
- Fig. 3: provides an enlarged detail view of a section marked in Fig. 2.
- Fig. 4: schematically illustrates a side view of a vehicle comprising the vehicular electronic control unit according to an embodiment.
- Fig. 5: provides a schematic block chart illustrating a method of producing a vehicular electronic control unit according to an embodiment.

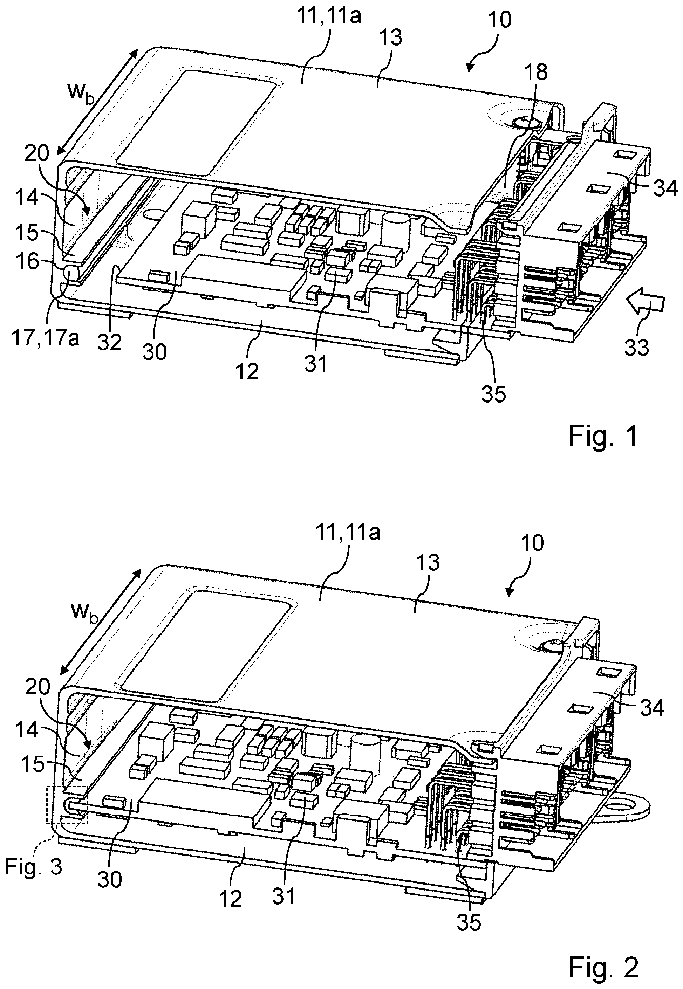

Figs. 1 and 2 illustrate a vehicular electronic control unit 10 (vehicular ECU 10) according to an embodiment. In Fig. 1, the vehicular ECU 10 is shown in a state in which a printed circuit board 30 with electronic components 31 mounted thereon is partially inserted into a housing 11 of the vehicular ECU 10 in a direction of insertion 33. In Fig. 2, the vehicular ECU 10 is shown in a state in which the printed circuit board 30 is fully inserted into the housing 11.

As apparent from Figs. 1 and 2, the housing 11 comprises a base 12, a cover 13 and a back wall 14 connecting the base 12 with the cover 13. Furthermore, the housing 11 comprises side walls 18 extending perpendicular to the base 12, the cover 13 and the back wall 14, of which only one side wall 18 is visible due to the sectional views provided in Figs. 1 and 2. At least one of the base 12, the cover 13, the back wall 14 and the side walls 18 may be configured as a detachable part of the housing 11. Preferably, the base 12, the cover 13, the back wall 14 and the side walls 18 form integral components of the housing 11. The housing 11 may, for instance, be an aluminum housing or a synthetic housing. According to non-limiting examples, the housing 11 may be manufactured by deep drawing, injection molding, sheet metal bending, 3D printing, etc.

In Figs. 1 and 2, it is shown that a PCB holder 15 protrudes from the back wall 14 of the housing 11, and Fig. 2 illustrates that the fully inserted printed circuit board 30 is supported by the PCB holder 15.

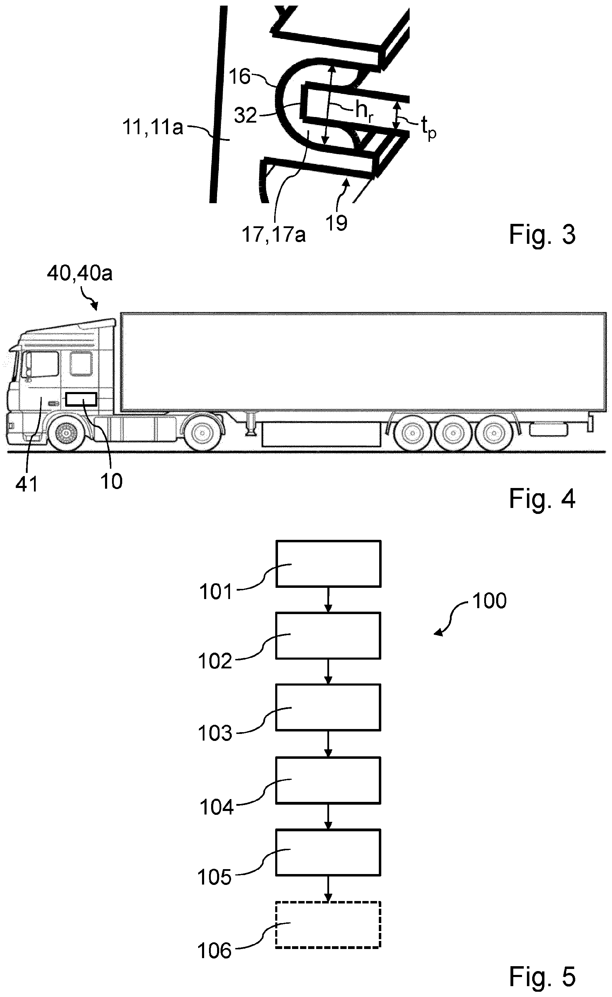

As further apparent from Figs. 1 and 2 as well as from the enlarged detail view provided in Fig. 3, the PCB holder 15 comprises a recess 16 extending in parallel to an outer edge 32 of the printed circuit board 30. The PCB holder 15 and the recess 16 may essentially extend along the width w_{b} of the back wall 14. As illustrated, the PCB holder 15 may be formed as an elongated rail with a groove extending along the length of the rail, the groove forming the recess 16.

It is depicted in Figs. 1 to 3 that the recess 16 is filled with an elastic material 17. According to the depicted embodiment, the elastic material 17 is a foam material 17a, which is easy to process and comprises beneficial properties for a soft holding of the printed circuit board 30. As depicted in Figs. 2 and 3, the outer edge 32 of the printed circuit board 30 is pushed into the elastic material 17 when the printed circuit board 30 is fully inserted into the housing 11. The printed circuit board 30 may be supported by the illustrated PCB holder 15 in a soft and resilient manner, since the recess 16 filled with an elastic material 17 forms a flexible clamp holder for holding the outer edge 32 of the printed circuit board 30.

The PCB holder 15 according to the depicted embodiment may significantly reduce mechanical stress and the risk of micro cracks or damages of the printed circuit board 30 during vehicle operation. In addition, the PCB holder 15 with the recess 16 filled with an elastic material 17 may provide beneficial vibration damping. With the elastic material 17, tolerance compensation may be achieved regarding the form and dimensions of the printed circuit board 30. Furthermore, the presented support concept facilitates the assembly and handling of the vehicular ECU 10.

According to the embodiment depicted in Figs. 1 and 2, the housing 11 is configured as a rack housing 11a for slidable insertion of the printed circuit board 30. As shown in Fig. 1, the back wall 14 is facing a leading outer edge 32 of the printed circuit board 30 in the direction of insertion 33. Although not visible due to the perspective views in Figs. 1 and 2, at least one side wall 18 adjacent to the back wall 14 comprises a guiding element, such as a guiding rail, which receives the printed circuit board 30 in a slidable manner. As apparent from Figs. 1 and 2, the printed circuit board 30 may be easily inserted into the housing 11 using the guiding element. The PCB holder 15 becomes effective at the end of the insertion of the printed circuit board 30, thus improving the assembly and handling of the vehicular ECU 10. Furthermore, the guiding element may improve the hold of the printed circuit board 30 in the housing 11 as a further support structure.

It is apparent from Figs. 1 and 2 that the PCB holder 15 is formed as continuous bar 20 extending along the width w_{b} of the back wall 14, thus presenting an elongated horizontal PCB holder 15 for space-saving installation and extended force absorption over the width extension of the PCB holder 15. According to the shown embodiment, the PCB holder 15 extends over the whole width w_{b} of the back wall 14. According to other embodiments, the continuous bar may be shorter or divided into at least two spaced PCB holders 15 protruding from the back wall 14 for economical material use.

According to the embodiment depicted in Figs. 1 and 2, the back wall 14 is formed integrally with the base 12 and the cover 13 of the housing 11 which may contribute to a stable and tight structure of the housing 11. Alternatively, the back wall 14 may be provided as a detachable lid of the housing 11 for increased flexibility. On the opposite of the back wall 14, a connector panel 34 is connected to the printed circuit board 30 by solder connections 35. The connector panel 34 forms a detachable front closure of the housing 11 when the printed circuit board 30 is fully inserted into the housing 11.

According to the embodiment shown in Figs. 1 and 2, the PCB holder 15 is configured as an integral component of the housing 11, being produced in one piece with the housing 11 except for the elastic material 17. In this way, a robust and stable PCB holder 15 which is easy to manufacture in one piece with the housing 11 may be provided. Alternatively, the PCB holder 15 may be provided as a separate component being attached to the housing 11 for increased use flexibility.

Fig. 3 provides an enlarged view of the PCB holder 15 and shows that the PCB holder 15 comprises a holder profile 19 with an open cross-section. In accordance with the depicted embodiment, the holder profile 19 comprises a U-shape in order to form a robust flexible clamp holder which is easy to manufacture and provides enhanced hold of the elastic material 17 in the recess 16.

As further indicated in Fig. 3, the recess 16 comprises a height hᵣ being larger than the thickness tp of the printed circuit board 30 for providing enough space for the elastic material 17 and for reliable compensation of potential thickness variations of the printed circuit board 30. As depicted, the recess 16 may be at least 10 % higher than the printed circuit board 30 for an enhanced effect. As illustrated, the elastic material 17 partially covers a top side and an underside of the printed circuit board 30 in the area of the outer edge 32, thus providing a soft and reliable hold.

In Fig. 4, a side view of a vehicle 40 according to an embodiment is schematically illustrated. The vehicle 40 is configured as a commercial vehicle 40a and shown as a truck and trailer combination. The truck comprises a cabin 41 and a vehicular ECU 10 installed in the cabin 41. The vehicular ECU 10 may, for instance, be a driver assistance control unit. The vehicular ECU 10 may be configured according to any aspect or embodiment described herein. According to a non-limiting example, the vehicular ECU 10 may be configured as illustrated in Figs. 1 to 3. Generally, commercial vehicles 40a may be prone to intense vibration and shock forces. Although a cabin damping system may already reduce these forces acting on the printed circuit board 30, it may be beneficial to provide an improved vehicular ECU 10 with enhanced damping and flexible holding properties as presented above. By providing a vehicular ECU 10 with a PCB holder 15 acting as a flexible clamp holder on a back wall 14 of the vehicular ECU 10, vehicle-related functions performed by electrical components 31 mounted on the printed circuit board 30 can be maintained in a reliable manner, thus contributing to an enhanced overall operation efficiency of the vehicle 40, here in particular of the truck.

Fig. 5 provides a simplified block chart illustrating a method 100 of producing a vehicular ECU 10 according to an embodiment. The order of the blocks representing steps 101 to 106 of the method 100 may rather be seen as a conceptual scheme than as a strict chronological sequence. Hence, at least some of the steps 101 to 106 may be exchanged or mixed during a production process for manufacturing the vehicular ECU 10.

According to the embodiment illustrated in Fig. 5, the method 100 comprises a step of providing 101 a housing 11 with a base 12, a cover 13 and a back wall 14 connecting the base 12 with the cover 13. According to a further step, the back wall 14 may be equipped 102 with a PCB holder 15 either by integral manufacturing or by subsequent attachment. A further step comprises filling 103 elastic material 17 into a recess 16 of the PCB holder 15. Furthermore, the method 100 comprises a step of inserting 104 a printed circuit board 30 into the housing 11 and a step of joining 105 an outer edge 32 of the printed circuit board 30 with the elastic material 17 in the PCB holder 15 protruding from the back wall 14. Optionally, the step of joining 105 the outer edge 32 of the printed circuit board 30 with the elastic material 17 may be conducted while the elastic material 17 is still curing. According to a further optional step, the housing 11 may be sealed 106 with the same elastic material 17 being filled into the recess 16 of the PCB holder 15, thus allowing for an efficient multifunctional use of the elastic material 17.

With the vehicular ECU 10, the housing 11 and the vehicle 40 described above, mechanical stress in the printed circuit board 30 of the vehicular ECU 10 may be reduced, tolerance compensation regarding the shape and dimensions of the printed circuit board 30 may be enabled, vibration damping may be provided, a space-saving holding structure may be presented and overall operation efficiency of the vehicle 40 may be improved. The vehicular ECU 10 can be manufactured in an easy and cost-effective manner, for instance by applying the method 100 of producing the vehicular ECU 10 as described above.

### List of reference numerals (part of the description):

- 10: vehicular electronic control unit
- 11: housing
- 11a: rack housing
- 12: base
- 13: cover
- 14: back wall
- 15: PCB holder
- 16: recess
- 17: elastic material
- 17a: foam material
- 18: side wall
- 19: holder profile
- 20: continuous bar
- 30: printed circuit board
- 31: electronic component
- 32: outer edge
- 33: direction of insertion
- 34: connector panel
- 35: solder connections
- 40: vehicle
- 40a: commercial vehicle
- 41: cabin
- 100: method for producing a vehicular electronic control unit
- 101: providing a housing with a back wall
- 102: equipping the back wall with a PCB holder
- 103: filling elastic material into a recess of the PCB holder
- 104: inserting a printed circuit board into the housing
- 105: joining an outer edge of the printed circuit board with the elastic material
- 106: optional sealing the housing with the same elastic material
- hᵣ: height of recess
- tₚ: thickness of printed circuit board
- w_{b}: width of back wall

## Claims

1. A vehicular electronic control unit (10), comprising:
- a housing (11) with a base (12), a cover (13) and a back wall (14) connecting the base (12) with the cover (13),
- a PCB holder (15) protruding from the back wall (14) of the housing (11), and
- a printed circuit board (30) supported by the PCB holder (15) and having electronic components (31) mounted thereon,
wherein:
- the PCB holder (15) comprises a recess (16) extending in parallel to an outer edge (32) of the printed circuit board (30),
- the recess (16) is at least partially filled with an elastic material (17), and
- the outer edge (32) of the printed circuit board (30) is pushed into the elastic material (17).

2. The vehicular electronic control unit (10) according to claim 1, wherein the elastic material (17) is a foam material (17a).

3. The vehicular electronic control unit (10) according to claim 1 or 2, wherein
- the housing (11) is configured as a rack housing (11a) for slidable insertion of the printed circuit board (30),
- the back wall (14) is facing a leading outer edge (32) of the printed circuit board (30) in a direction of insertion (33), and
- at least one side wall (18) adjacent to the back wall (14) comprises a guiding element receiving the printed circuit board (30) in a slidable manner.

4. The vehicular electronic control unit (10) according to any preceding claim, wherein the PCB holder (15) comprises a holder profile (19) with an open cross-section.

5. The vehicular electronic control unit (10) according to any preceding claim, wherein the recess (16) comprises a height (hᵣ) being larger than the thickness (tₚ) of the printed circuit board (30).

6. The vehicular electronic control unit (10) according to any preceding claim, wherein the PCB holder (15) is formed as a continuous bar (20) extending along the width (w_{b}) of the back wall (14).

7. The vehicular electronic control unit (10) according to any preceding claim, wherein at least two spaced PCB holders (15) protrude from the back wall (14).

8. The vehicular electronic control unit (10) according to any preceding claim, wherein the back wall (14) is configured as a detachable lid of the housing (11).

9. The vehicular electronic control unit (10) according to any preceding claim, wherein the PCB holder (15) is an integral component of the housing (11).

10. The vehicular electronic control unit (10) according to any of claims 1 to 8, wherein the PCB holder (15) is a separate component being attached to the housing (11).

11. A housing (11) for the vehicular electronic control unit (10) according to any preceding claim, wherein
- the housing (11) comprises a base (12), a cover (13) and a back wall (14) connecting the base (12) with the cover (13),
- the housing (11) comprises a PCB holder (15) protruding from the back wall (14) of the housing (11), the PCB holder (15) being configured to support a printed circuit board (30),
- the PCB holder (15) comprises a recess (16), and
- the recess (16) is at least partially filled with an elastic material (17).

12. A vehicle (40), in particular a commercial vehicle (40a), comprising the vehicular electronic control unit (10) according to any of claims 1 to 10.

13. A method (100) for producing a vehicular electronic control unit (10) according to any of claims 1 to 10, comprising the steps of:
- providing (101) a housing (11) with a base (12), a cover (13) and a back wall (14) connecting the base (12) with the cover (13),
- equipping (102) the back wall (14) with a PCB holder (15) either by integral manufacturing or by subsequent attachment,
- filling (103) elastic material (17) into a recess (16) of the PCB holder (15),
- inserting (104) a printed circuit board (30) into the housing (11), and
- joining (105) an outer edge (32) of the printed circuit board (30) with the elastic material (17) in the PCB holder (15) protruding from the back wall (14).

14. The method (100) according to claim 13, further comprising the step of sealing (106) the housing (11) with the same elastic material (17) being filled into the recess (16) of the PCB holder (15).

15. The method (100) according to claim 13 or 14, wherein the step of joining (105) of the outer edge (32) of the printed circuit board (30) with the elastic material (17) is conducted while the elastic material (17) is still curing.
